# EUROPÄISCHE PATENTSCHRIFT

(11) **EP 0 781 424 B1**
(45) Veröffentlichungstag und Bekanntmachung des Hinweises auf die Patenterteilung: **18.11.1998**
(21) Anmeldenummer: 95929739.1
(22) Anmeldetag: 01.09.1995
(51) Int. Cl.: G03F 7/38, G03F 7/022

(54) **PHOTOLITHOGRAPHISCHE STRUKTURERZEUGUNG**
PHOTOLITHOGRAPHIC METHOD OF PRODUCING STRUCTURAL FEATURES
PRODUCTION DE STRUCTURES PAR PHOTOLITHOGRAPHIE

(30) Priorität: 12.09.1994 DE 4432445; 12.09.1994 DE 4432447
(43) Veröffentlichungstag der Anmeldung: 02.07.1997
(73) Patentinhaber: SIEMENS AKTIENGESELLSCHAFT, 80333 München (DE)
(72) Erfinder: SEZI, Recai, D-91341 Röttenbach (DE); LEUSCHNER, Rainer, D-91056 Erlangen (DE); SCHMIDT, Erwin, D-91058 Erlangen (DE)
(86) Internationale Anmeldenummer: DE9501187
(87) Internationale Veröffentlichungsnummer: WO9608751

(56) Entgegenhaltungen:
- EP-A- 0 351 849
- EP-A- 0 369 219
- WO-A-94/02885
- US-A- 5 314 782
- PRZYBILLA K J ET AL 'Delay time stable chemically amplified deep UV resist' , ADVANCES IN RESIST TECHNOLOGY AND PROCESSING X, SAN JOSE, CA, USA, 1-2 MARCH 1993 , ISSN 0277-786X, PROCEEDINGS OF THE SPIE - THE INTERNATIONAL SOCIETY FOR OPTICAL ENGINEERING, 1993, USA, PAGE(S) 76 - 91
- SCHWALM R ET AL 'A robust and environmentally stable deep UV positive resist: optimisation of SUCCESS ST2' , ADVANCES IN RESIST TECHNOLOGY AND PROCESSING XI, SAN JOSE, CA, USA, 28 FEB.-1 MARCH 1994 , ISSN 0277-786X, PROCEEDINGS OF THE SPIE - THE INTERNATIONAL SOCIETY FOR OPTICAL ENGINEERING, 1994, USA, PAGE(S) 2 - 13
- JAGANNATHAN P ET AL 'Environmentally stable chemically amplified DUV resist based on diazoketone chemistry' , ADVANCES IN RESIST TECHNOLOGY AND PROCESSING XI, SAN JOSE, CA, USA, 28 FEB.-1 MARCH 1994 , ISSN 0277-786X, PROCEEDINGS OF THE SPIE - THE INTERNATIONAL SOCIETY FOR OPTICAL ENGINEERING, 1994, USA, PAGE(S) 28 - 36
- DATABASE WPI Section Ch, Week 9303 Derwent Publications Ltd., London, GB; Class A89, AN 93-021675 & JP-A-04 347 857 ( TOSHIBA KK) , 3.Dezember 1992

## Beschreibung

Die Erfindung betrifft ein Verfahren zur photolithographischen Strukturerzeugung - mittels eines naßentwickelbaren Einlagenresistsystems bzw. mittels eines Zweilagenresistsystems - im Submikron-Bereich.

In der Mikroelektronik werden in großem Umfang sogenannte chemisch verstärkte Resists ("chemically amplified resists") eingesetzt (siehe dazu: "Solid State Technology", Vol. 34 (1991), No. 8, Seiten 53 bis 60). Die chemische Verstärkung findet sowohl bei naßentwickelbaren Einlagenresists Anwendung als auch bei ganz oder teilweise trockenentwickelbaren Resists. Die Resists können dabei nach dem Prinzip der säurekatalytischen Spaltung arbeiten, wobei polare, aber mit einer Schutzgruppe blockierte chemische Gruppen, beispielsweise Carboxylgruppen oder phenolische Hydroxylgruppen, durch eine photolytisch erzeugte Säure deblockiert werden und der Resist in den belichteten Bereichen seine Polarität ändert. Diese Polaritätsänderung kann beispielsweise für das Entwickeln oder für eine selektive Silylierung genutzt werden.

Zur schnellen Abspaltung der Schutzgruppe wird der Resist nach der Belichtung einer Temperaturbehandlung (Post Exposure Bake = PEB) unterworfen; dadurch wird die Deblockierung in Gang gesetzt bzw. beschleunigt. Beispiele für blockierende Gruppen sind tert.-Butylester- und tert.-Butoxycarbonyloxygruppen (t-Boc-Gruppen). Die Polaritätsänderung bewirkt in den belichteten und in den unbelichteten Bereichen eine unterschiedliche Löslichkeit, d.h. der Resist kann - mit geeigneten Entwicklern - gezielt positiv (Herauslösen der belichteten Bereiche) oder negativ (Herauslösen der unbelichteten Bereiche) entwickelt werden.

Der Resist besteht im allgemeinen mindestens aus zwei festen Bestandteilen, d.h. aus einem Basispolymer, das tert.-Butylester- oder t-Boc-Gruppen aufweist, und einem photoaktiven Säurebildner. Resists, die Polymere mit derartigen Gruppen enthalten, sind beispielsweise aus der US-PS 4 491 628 bekannt. Der Säurebildner ist vorzugsweise eine Oniumverbindung, wie Diphenyljodonium- und Triphenylsulfonium-trifluormethansulfonat bzw. die entsprechenden Hexafluorarsenate. Derartige Resists eignen sich insbesondere für die Photostrukturierung im Submikron- und Subhalbmikron-Bereich.

Aus der EP-OS 0 494 383 ist eine photolithographische Strukturerzeugung mittels der Zweilagenresisttechnik bekannt, bei der - nach der Belichtung, einer anschließenden Temperaturbehandlung (Post Exposure Bake = PEB) und dem Entwickeln - aus flüssiger Phase silyliert und dann in einem Sauerstoffplasma anisotrop geätzt wird. Je nach der Art der Silylierungslösung werden dabei positive oder negative Strukturen erzeugt. Der Resist besteht im allgemeinen mindestens aus zwei festen Bestandteilen, d.h. aus einem Basispolymer und einem photoaktiven Säurebildner. Das Basispolymer enthält Carbonsäureanhydrid- und tert.-Butylester-Partialstrukturen, der Säurebildner ist vorzugsweise eine Oniumverbindung, wie Diphenyljodonium- und Triphenylsulfonium-trifluormethansulfonat. Ein derartiger Resist eignet sich insbesondere für die Photostrukturierung im Submikron- und Subhalbmikron-Bereich mit sehr steilen Flanken.

Bei einer Strukturerzeugung in der vorstehend geschilderten Weise wurde - ebenso wie bei anderen bekannten Resistsystemen, welche nach dem Prinzip der säurekatalytischen Spaltung bzw. nach dem Prinzip der chemischen Verstärkung arbeiten - der sogenannte Standzeit-Effekt festgestellt. Wenn nämlich die Zeitspanne ("delay time") zwischen der Belichtung und der Temperaturbehandlung (PEB) einen bestimmten Wert übersteigt, dann treten deutliche Abweichungen zwischen der nominalen Strukturdimension (Strukturgröße auf der Maske) und der abgebildeten Struktur (Strukturgröße im Resist nach der Entwicklung) auf. Je länger diese Zeitspanne ist, um so größer ist die Abweichung. Ab einem bestimmten Wert für die Zeitspanne, bei anhydridgruppenhaltigen Resists der vorstehend genannten Art beispielsweise ca. 30 min, sind nach der Entwicklung kaum noch Strukturen erkennbar. Die tolerable Zeitspanne beträgt bei diesen Resists ca. 5 bis 10 min. Eine derartige Zeitspanne kann aus produktionstechnischen Gründen jedoch nicht akzeptiert werden.

Für einen im tiefen UV-Bereich wirksamen Positivresist beispielsweise wird eine Standzeit von 1 h angegeben (siehe: "Microelectronic Engineering", Vol. 21 (1993), Seiten 267 bis 270). Für die Produktion sind jedoch wesentlich längere Standzeiten wünschenswert, wobei von Vorteil wäre, wenn belichtete Resists notfalls auch über Nacht gelagert werden könnten, d.h. die Standzeit ≥ 15 h betragen würde.

Das geschilderte Problem ist allgemein bekannt und wird auf basische Kontaminationen in der Luft zurückgeführt, die während der Standzeit die photochemisch erzeugte starke Säure desaktivieren. Deshalb wurde bereits vorgeschlagen, dieses Problem durch Filtration der Luft mittels Aktivkohle zu lösen (siehe: "Proc. SPIE", Vol. 1466 (1991), Seiten 2 bis 12). Dies erfordert aber hohe Investitionen.

Auch durch andere Maßnahmen, beispielsweise durch Zusatz von Additiven, konnte der Standzeiteffekt nicht entscheidend abgeschwächt werden (siehe: "Proc. SPIE", Vol. 1466 (1991), Seiten 13 bis 25). Eine Verlängerung der Standzeit ist zwar durch Aufbringen einer zusätzlichen Schicht möglich, aber nur im geringen Ausmaß. Außerdem stellt diese Maßnahme einen zusätzlichen Prozeßschritt dar, was aber in der Produktion unerwünscht ist, weil es zu Ausbeuteverlusten führt.

Aufgabe der Erfindung ist es, ein - nach dem Prinzip der säurekatalytischen Spaltung arbeitendes - Verfahren zur photolithographischen Strukturerzeugung anzugeben, mit dem - bei Resistsystemen der eingangs genannten Art - das Standzeitproblem ohne zusätzliche Prozeßschritte bzw. Investitionen gelöst werden kann, d.h. die Standzeit zwischen Belichtung und Temperaturbehandlung auf ein produktionstechnisch akzeptables Niveau erhöht wird.

Dies wird erfindungsgemäß dadurch erreicht (Variante 1),
- daß auf ein Substrat eine Photoresistschicht aufgebracht wird, bestehend aus
   einem tert.-Butylester- oder tert.-Butoxycarbonyloxygruppen enthaltenden Polymer,
   einer photoaktiven Komponente in Form eines Esters einer Naphthochinondiazid-4-sulfonsäure der Struktur 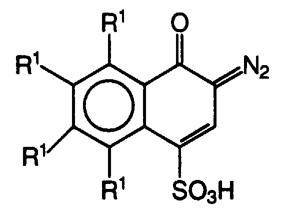 mit einer aromatischen Hydroxyverbindung der Struktur 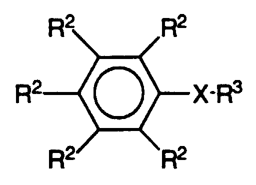 wobei folgendes gilt:
      - R¹ =: H, Alkyl, Halogenalkyl, Alkoxy, Phenyl, Halogenphenyl, Phenoxy oder Halogen,
      - R² =: H, OH, Alkyl, Halogenalkyl, Alkoxy, Phenyl, Halogenphenyl, Phenoxy oder Halogen,
      - R³ =: Alkyl, Halogenalkyl, Phenyl, Halogenphenyl oder Mono-, Di- oder Trihydroxyphenyl und
      - X =: CO oder SO₂,
      mit der Maßgabe, daß die Hydroxyverbindung wenigstens eine OH-Gruppe aufweist und an die Hydroxyverbindung - über SO₂-O-Gruppierungen- 1 bis 4 Naphthochinondiazid-4-sulfonsäurereste gebunden sind,
      und einem geeigneten Lösungsmittel,
- daß die Photoresistschicht getrocknet wird,
- daß die Photoresistschicht bildmäßig belichtet wird,
- daß die belichtete Photoresistschicht einer Temperaturbehandlung im Bereich zwischen 120 und 150°C für die Dauer von 100 bis 600 s ausgesetzt wird,
- und daß die derart behandelte Photoresistschicht naß entwickelt wird.

Dieser Variante des Verfahrens nach der Erfindung liegt ein lagerstabiler naßentwickelbarer Einlagenresist, d.h. Positivresist, auf der Basis eines Polymers zugrunde, das tert.-Butylester- oder tert.-Butoxycarbonyloxygruppen besitzt. Ein derartiger Resist hat den Vorteil, daß er nicht nur im tiefen UV-Bereich (DUV), sondern auch im nahen UV-Bereich (NUV) wirksam ist.

Alternativ zum vorstehend geschilderten Verfahren kann auch in der Weise vorgegangen werden (Variante 2),
- daß auf ein Substrat ein Bottomresist aufgebracht wird,
- daß auf den Bottomresist als Topresist eine Schicht eines Photoresists aufgebracht wird, bestehend aus
   einem Carbonsäureanhydridgruppen und tert.-Butylester- oder tert.-Butoxycarbonyloxygruppen enthaltenden Polymer,
   einer photoaktiven Komponente in Form eines Esters der vorstehend genannten Art
   und einem geeigneten Lösungsmittel,
- daß die Resistschicht getrocknet wird,
- daß die Resistschicht bildmäßig belichtet wird,
- daß die belichtete Resistschicht einer Temperaturbehandlung im Bereich zwischen 120 und 150°C für die Dauer von 100 bis 600 s ausgesetzt wird,
- daß der derart behandelte Topresist naß entwickelt wird,
- daß der Topresist silyliert wird,
- und daß der Bottomresist in einem anisotropen Sauerstoffplasma trocken entwickelt wird.

Diesem alternativen Verfahren nach der Erfindung, das nach der Zweilagenresisttechnik arbeitet, liegt ein lagerstabiler naßentwickelbarer Topresist auf der Basis eines Polymers zugrunde, das - neben tert.-Butylester- oder tert.-Butoxycarbonyloxygruppen - Carbonsäureanhydridgruppen besitzt. Auch dieser Resist hat den Vorteil, daß er nicht nur im tiefen UV-Bereich (DUV), sondern auch im nahen UV-Bereich (NUV) wirksam ist.

Die photoaktive Komponente des Resists ist ein Ester aus einer Naphthochinondiazid-4-sulfonsäure und einer aromatischen Hydroxyverbindung. Derartige photoaktive Komponenten sind an sich zwar bekannt (siehe dazu: "Methods and Materials in Microelectronic Technology", Plenum Press, New York (1984), Seiten 190 bis 193). Bei der Erfindung ist jedoch die gute Strukturierbarkeit des eine derartige photoaktive Komponente enthaltenden Resists überraschend. Bei der photolithographischen Strukturerzeugung sind nämlich bei tert.-butylesterhaltigen Basispolymeren in der Regel sehr starke Säurebildner erforderlich. Wichtig ist auch, daß die Hydroxyverbindung eine bestimmte Struktur aufweist, und zwar diejenige eines hydroxylgruppenhaltigen aromatischen Ketons oder Sulfons. Ester mit Verbindungen wie Bisphenol-A eignen sich nämlich beim erfindungsgemäßen Verfahren nicht als photoaktive Komponente.

Beim Verfahren nach der Erfindung ist wesentlich, daß die Temperaturbehandlung (PEB) relativ lange dauert, nämlich ≥ 100 s, d.h. zwischen 100 und 600 s, und die PEB-Temperatur relativ hoch ist, nämlich 120 bis 150°C. Bei diesem Verfahren ergibt sich eine Verlängerung der Standzeit bis zu 16 h und mehr. Das Standzeitproblem wird dabei gelöst, ohne daß neue Verfahrensschritte bzw. neue Materialien erforderlich sind und ohne die Notwendigkeit von neuen Investitionen.

Im Vergleich zu gängigen Resists ist bei der Erfindung der Anteil an photoaktiver Komponente deutlich höher. Dieser Anteil beträgt vorteilhaft 20 bis 40 Masse-%, vorzugsweise 25 bis 35 Masse-%, bezogen auf den trockenen Photoresist, d.h. die lösungsmittelfreie Resistzusammensetzung. Vorteilhaft kann die photoaktive Komponente auch ein Gemisch aus einem Ester der genannten Art und einer Oniumverbindung sein. Derartige Verbindungen, die auch als Crivellosalze bezeichnet werden, sind beispielsweise Diphenyljodonium-trifluormethansulfonat (DPIT) und Triphenylsulfonium-trifluormethansulfonat (TPST). Im Ester der photoaktiven Komponente dient als Hydroxyverbindung vorzugsweise 2,3,4-Trihydroxybenzophenon.

Beim Verfahren nach der Erfindung werden beim Einlagenresistsystem, d.h. bei der Variante 1, vorzugsweise solche Polymere eingesetzt, bei denen den Carbonsäure-tert.-butylestergruppen Acrylsäure-, Methacrylsäure-, Vinylbenzoesäure- oder Zimtsäure-tert.-butylester zugrunde liegt. Die tert.-Butoxycarbonyloxygruppen leiten sich vorzugsweise von tert.-Butoxycarbonyloxystyrol oder -maleinimid ab.

Beim Zweilagenresistsystem, d.h. bei der Variante 2, werden beim Verfahren nach der Erfindung vorzugsweise solche Polymere eingesetzt, deren Carbonsäureanhydridgruppen sich von Maleinsäureanhydrid ableiten. Eine andere Verbindung dieser Art ist beispielsweise Itaconsäureanhydrid. Den Carbonsäure-tert.-butylestergruppen liegt ebenfalls vorzugsweise Acrylsäure-, Methacrylsäure-, Vinylbenzoesäure- oder Zimtsäure-tert.-butylester zugrunde, den tert.-Butoxycarbonyloxygruppen vorzugsweise tert.-Butoxycarbonyloxystyrol oder -maleinimid.

Der Bottomresist, der gegen Substratätzprozesse resistent sein muß, weist im allgemeinen ein aromatenhaltiges Polymer auf, üblicherweise auf Novolak-Basis. Nach dem Aufbringen auf das Substrat wird der Bottomresist ausgeheizt. Dabei erfolgt eine Quervernetzung des Polymers, wodurch dieses für Topresist-Lösungsmittel unlöslich wird. Nach dem Ausheizen wird auf den Bottomresist der Topresist aufgebracht, bei dem eine Ätzresistenz gegen Trockenentwicklung im Sauerstoffplasma nicht erforderlich ist. Nach der Trocknung des Topresists erfolgt die bildmäßige Belichtung, die Temperaturbehandlung, die Naßentwicklung (mit einem alkalischen Entwickler) und die Silylierung. Anschließend wird dann die Struktur - im anisotropen Sauerstoffplasma - in den Bottomresist übertragen.

Als Lösungsmittel dienen an sich bekannte Resistlösungsmittel. Wichtig für die Auswahl des Lösungsmittels ist allein das Erfordernis, daß sowohl die Polymerkomponente als auch der Photoinitiator, d.h. die photoaktive Komponente, gelöst werden muß. Außerdem müssen - mit den bekannten Beschichtungsverfahren - fehlerfreie Resistschichten auf den Substraten gebildet werden, beispielsweise auf Siliciumwafern bzw. auf mit einem Bottomresist beschichteten Wafern. Vorzugsweise ist das Lösungsmittel Cyclohexanon, Methoxypropylacetat oder ein Ethylenglykol- bzw. Diethylenglykolether, gegebenenfalls im Gemisch mit Dibenzylether.

Durch die Silylierung, die aus flüssiger Phase erfolgt (Flüssigsilylierung), wird beim Verfahren nach der Erfindung eine Ätzresistenz des Topresists gegen Trockenentwicklung im Sauerstoffplasma bewirkt. Dazu wird die Resistschicht mit einer polaren, protischen Silylierungslösung behandelt. Als Silylierungsagens dienen im allgemeinen Siliciumverbindungen in Form von Aminosilanen oder Aminosiloxanen; diese Verbindungen können oligomerer Natur sein. Die Silylierungslösung ist vorzugsweise eine alkoholische Lösung des Silylierungsagens; dabei wird das Silylierungsagens vorteilhaft in Gemischen von Ethanol und Isopropanol gelöst. Daneben können beispielsweise auch Gemische mit anderen organischen Lösungsmitteln zum Einsatz gelangen.

Anhand von Ausführungsbeispielen soll die Erfindung noch näher erläutert werden. Dabei finden folgende Ausgangsmaterialien bzw. Reagenzien Verwendung (MT = Masseteile):
- Basispolymer (1)
   Copolymer aus Methacrylsäure-tert.-butylester und Methacrylsäuremethylester, hergestellt durch radikalische Polymerisation der beiden Monomere in Ethylacetat mit Azoisobuttersäurenitril als Initiator.
- Basispolymer (2)
   Copolymer aus Methacrylsäure-tert.-butylester und Maleinsäureanhydrid, hergestellt durch radikalische Polymerisation der beiden Monomere in Ethylacetat mit Azoisobuttersäurenitril als Initiator.
- Photoaktive Komponente (1)
   Triester von 2,3,4-Trihydroxybenzophenon mit Naphthochinondiazid-4-sulfonsäure.
- Photoaktive Komponente (2)
   Diphenyljodonium-trifluormethansulfonat (DPIT).
- Entwicklerlösung
   Wäßrige, basisch reagierende Lösung in Form des kommerziellen metallionenfreien Photoresistentwicklers NMD-W 2,38 % (Fa. Tokyo Ohka Kogyo Co.).
- Silylierungslösung
   Alkoholische Lösung, bestehend aus 4 MT Diaminosiloxan, 50,3 MT Ethanol und 45,7 MT Isopropanol; vorzugsweise wird ein α,ω-aminofunktionelles Siloxan, insbesondere mit zwei endständigen Aminopropylgruppen und 2 bis 20 Siliciumatomen in der Kette, verwendet, beispielsweise das handelsübliche Produkt Tegomer A-Si 2120 (Fa. Goldschmidt).

### Beispiel 1

Auf einen Siliciumwafer wird ein Resist, bestehend aus 9,8 MT Basispolymer (1), 4,2 MT photoaktive Komponente (1) und 86 MT Cyclohexanon aufgeschleudert und 60 s bei 90°C auf einer Heizplatte getrocknet; die Schichtdicke des Resists beträgt 0,31 µm. Der Resist wird dann durch eine Maske mit 17 mJ/cm² kontaktbelichtet (Gerät MJB 3, Fa. Karl Süss; λ = 250 nm) und unmittelbar danach 120 s bei 140°C auf der Heizplatte getempert (PEB). Anschließend werden die belichteten Bereiche 60 s mit der Entwicklerlösung behandelt und herausgelöst, und dann wird 30 s mit Wasser gespült und 60 s bei 90°C auf der Heizplatte getrocknet. Es werden positive Strukturen mit einem Steg/Graben-Verhältnis von 1:1 erhalten.

### Beispiel 2

Es wird wie in Beispiel 1 vorgegangen, der Wafer wird jedoch zwischen der Belichtung und der Temperung 16 h in einer Waferhorde offen im Prozeßraum liegen gelassen. Nach dem Entwickeln werden ebenfalls positive Strukturen mit einem Steg/Graben-Verhältnis von 1:1 erhalten. Mikroskopische Untersuchungen zeigen, daß Strukturen gleicher Nominalbreite auf den Wafern nach Beispiel 1 und Beispiel 2 die gleiche Breite haben.

### Beispiel 3 (Vergleichsversuch)

Auf einen Siliciumwafer wird ein Resist, bestehend aus 12,2 MT Basispolymer (1), 0,8 MT photoaktive Komponente (2) und 87 MT Cyclohexanon aufgeschleudert und 60 s bei 90°C auf einer Heizplatte getrocknet; die Schichtdicke des Resists beträgt 0,34 µm. Der Resist wird dann durch eine Maske mit 12 mJ/cm² kontaktbelichtet (Gerät MJB 3, Fa. Karl Süss; λ = 250 nm) und unmittelbar danach 60 s bei 90°C auf der Heizplatte getempert (PEB). Anschließend werden die belichteten Bereiche 60 s mit der Entwicklerlösung behandelt und herausgelöst, und dann wird 30 s mit Wasser gespült und 60 s bei 90°C auf der Heizplatte getrocknet. Es werden positive Strukturen mit einem Steg/Graben-Verhältnis von 1:1 erhalten.

### Beispiel 4 (Vergleichsversuch)

Es wird wie in Beispiel 3 vorgegangen, der Wafer wird jedoch zwischen der Belichtung und der Temperung 1 h in einer Waferhorde offen im Prozeßraum liegen gelassen. Nach dem Entwickeln kann keine eindeutige Strukturierung festgestellt werden, d.h. hierbei tritt das Standzeitproblem auf.

### Beispiel 5

Auf einen Siliciumwafer (als Substrat) wird der käufliche Positivresist TSMR 8900 (Fa. Tokyo Ohka Kogyo Co.) aufgeschleudert und 60 s bei 90°C getrocknet; dann wird 35 min im Umluftofen bei 240°C ausgeheizt. Nach dem Ausheizen beträgt die Dicke des als Planarisierungsschicht dienenden Resists 1,1 µm.

Auf die Planarisierungsschicht wird ein Photoresist, bestehend aus 9,1 MT Basispolymer (2), 3,9 MT photoaktive Komponente (1) und 87 MT Methoxypropylacetat, aufgeschleudert und 60 s bei 90°C auf einer Heizplatte getrocknet; die Schichtdicke dieses Topresists beträgt 0,3 µm. Der Resist wird dann durch eine Maske mit 19 mJ/cm² kontaktbelichtet (Gerät MJB 3, Fa. Karl Süss; λ = 250 nm) und unmittelbar danach 120 s bei 140°C auf der Heizplatte getempert (PEB). Anschließend werden die belichteten Bereiche 90 s mit der Entwicklerlösung behandelt und herausgelöst, dann wird 30 s mit Isopropanol gespült und trockengeblasen. Nachfolgend wird der Topresist bei Raumtemperatur und Normaldruck, d.h. Raumklima, 90 s mit der Silylierungslösung behandelt, dann 30 s mit Isopropanol gespült und danach 60 s bei 90°C auf der Heizplatte getrocknet. Nach dem Trocknen wird der Wafer in eine Plasmaätzanlage (Typ MIE 720, Fa. Material Research Corporation) gebracht und der Resist, einschließlich der Planarisierungsschicht, zunächst mit einem Plasma geätzt, das Sauerstoff (Gasfluß: 80 sccm) und Tetrafluormethan (Gasfluß: 9 sccm) enthält; der gesamte Gasdruck beträgt 1,07 Pa (8 mTorr), die Biasspannung 40 V. Anschließend wird in reinem Sauerstoffplasma geätzt (Gasdruck: 0,27 Pa (2 mTorr); Biasspannung: 50 V). Es werden positive Strukturen mit senkrechten Flanken und einem Steg/Graben-Verhältnis von 1:1 erhalten.

### Beispiel 6

Es wird wie in Beispiel 5 vorgegangen, der Wafer wird jedoch zwischen der Belichtung und der Temperung 16 h in einer Waferhorde offen im Prozeßraum liegen gelassen. Nach dem Ätzen werden ebenfalls positive Strukturen mit senkrechten Flanken und einem Steg/Graben-Verhältnis von 1:1 erhalten. Mikroskopische Untersuchungen zeigen, daß Strukturen gleicher Nominalbreite auf den geätzten Wafern nach Beispiel 5 und Beispiel 6 die gleiche Breite haben.

### Beispiel 7 (Vergleichsversuch)

Auf eine entsprechend Beispiel 5 hergestellte Planarisierungsschicht (Dicke: 1,1 µm) wird ein Resist, bestehend aus 13,1 MT Basispolymer (2), 0,9 MT photoaktive Komponente (2) und 86 MT Diethylenglykoldimethylether aufgeschleudert und 60 s bei 90°C auf einer Heizplatte getrocknet; die Schichtdicke dieses Topresists beträgt 0,33 µm. Der Resist wird dann durch eine Maske mit 11 mJ/cm² kontaktbelichtet (Gerät MJB 3, Fa. Karl Süss; λ = 250 nm) und unmittelbar danach 60 s bei 90°C auf der Heizplatte getempert (PEB). Anschließend werden die belichteten Bereiche 60 s mit der Entwicklerlösung behandelt und herausgelöst, dann wird 30 s mit Wasser gespült und trockengeblasen. Nachfolgend wird der Topresist bei Raumtemperatur und Normaldruck, d.h. Raumklima, 90 s mit der Silylierungslösung behandelt, dann 30 s mit Isopropanol gespült und danach 60 s bei 90°C auf der Heizplatte getrocknet. Nach dem Trocknen wird der Resist, einschließlich der Planarisierungsschicht, in einer Plasmaätzanlage wie in Beispiel 5 geätzt. Es werden positive Strukturen mit senkrechten Flanken und einem Steg/Graben-Verhältnis von 1:1 erhalten.

### Beispiel 8 (Vergleichsversuch)

Es wird wie in Beispiel 7 vorgegangen, der Wafer wird jedoch zwischen der Belichtung und der Temperung 1 h in einer Waferhorde offen im Prozeßraum liegen gelassen. Nach dem Ätzen kann keine eindeutige Strukturierung festgestellt werden, d.h. hierbei tritt das Standzeitproblem auf.

## Patentansprüche

1. Verfahren zur photolithographischen Strukturerzeugung im Submikron-Bereich, **dadurch gekennzeichnet**,
- daß auf ein Substrat eine Photoresistschicht aufgebracht wird, bestehend aus
einem tert.-Butylester- oder tert.-Butoxycarbonyloxygruppen enthaltenden Polymer,
einer photoaktiven Komponente in Form eines Esters einer Naphthochinondiazid-4-sulfonsäure der Struktur 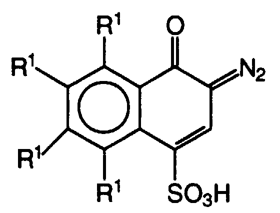 mit einer aromatischen Hydroxyverbindung der Struktur 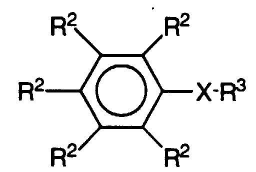 wobei folgendes gilt:
R¹ = H, Alkyl, Halogenalkyl, Alkoxy, Phenyl, Halogenphenyl, Phenoxy oder Halogen,
R² = H, OH, Alkyl, Halogenalkyl, Alkoxy, Phenyl, Halogenphenyl, Phenoxy oder Halogen,
R³ = Alkyl, Halogenalkyl, Phenyl, Halogenphenyl oder Mono-, Di- oder Trihydroxyphenyl und
X = CO oder SO₂,
mit der Maßgabe, daß die Hydroxyverbindung wenigstens eine OH-Gruppe aufweist und an die Hydroxyverbindung - über SO₂-O-Gruppierungen- 1 bis 4 Naphthochinondiazid-4-sulfonsäurereste gebunden sind,
und einem geeigneten Lösungsmittel,
- daß die Photoresistschicht getrocknet wird,
- daß die Photoresistschicht bildmäßig belichtet wird,
- daß die belichtete Photoresistschicht einer Temperaturbehandlung im Bereich zwischen 120 und 150°C für die Dauer von 100 bis 600 s ausgesetzt wird,
- und daß die derart behandelte Photoresistschicht naß entwickelt wird.

2. Verfahren zur photolithographischen Strukturerzeugung im Submikron-Bereich, **dadurch gekennzeichnet**,
- daß auf ein Substrat ein Bottomresist aufgebracht wird,
- daß auf den Bottomresist als Topresist eine Schicht eines Photoresists aufgebracht wird, bestehend aus
einem Carbonsäureanhydridgruppen und tert.-Butylester- oder tert.-Butoxycarbonyloxygruppen enthaltenden Polymer,
einer photoaktiven Komponente in Form eines Esters einer Naphthochinondiazid-4-sulfonsäure der Struktur 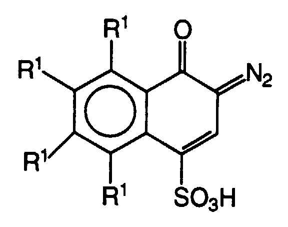 mit einer aromatischen Hydroxyverbindung der Struktur 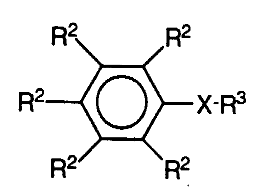 wobei folgendes gilt:
R¹ = H, Alkyl, Halogenalkyl, Alkoxy, Phenyl, Halogenphenyl, Phenoxy oder Halogen,
R² = H, OH, Alkyl, Halogenalkyl, Alkoxy, Phenyl, Halogenphenyl, Phenoxy oder Halogen,
R³ = Alkyl, Halogenalkyl, Phenyl, Halogenphenyl oder Mono-, Di- oder Trihydroxyphenyl und
X = CO oder SO₂,
mit der Maßgabe, daß die Hydroxyverbindung wenigstens eine OH-Gruppe aufweist und an die Hydroxyverbindung - über SO₂-O-Gruppierungen- 1 bis 4 Naphthochinondiazid-4-sulfonsäurereste gebunden sind,
und einem geeigneten Lösungsmittel,
- daß die Resistschicht getrocknet wird,
- daß die Resistschicht bildmäßig belichtet wird,
- daß die belichtete Resistschicht einer Temperaturbehandlung im Bereich zwischen 120 und 150°C für die Dauer von 100 bis 600 s ausgesetzt wird,
- daß der derart behandelte Topresist naß entwickelt wird,
- daß der Topresist silyliert wird,
- und daß der Bottomresist in einem anisotropen Sauerstoffplasma trocken entwickelt wird.

3. Verfahren nach Anspruch 1 oder Anspruch 2, **dadurch gekennzeichnet**, daß die Hydroxyverbindung 2,3,4-Trihydroxybenzophenon ist.

4. Verfahren nach einem der Ansprüche 1 bis 3, **dadurch gekennzeichnet**, daß der Anteil des Photoresists an photoaktiver Komponente 20 bis 40 Masse-% beträgt, vorzugsweise 25 bis 35 Masse-%.

5. Verfahren nach einem der Ansprüche 1 bis 4, **dadurch gekennzeichnet**, daß der photoaktiven Komponente eine Oniumverbindung zugesetzt wird.

6. Verfahren nach Anspruch 1, **dadurch gekennzeichnet**, daß ein Polymer verwendet wird, dessen tert.-Butylestergruppen Acrylsäure-, Methacrylsäure-, Vinylbenzoesäure- oder Zimtsäure-tert.-butylester zugrunde liegt.

7. Verfahren nach Anspruch 6, **dadurch gekennzeichnet**, daß ein Copolymer aus Methacrylsäure-tert.-butylester und Methacrylsäuremethylester verwendet wird.

8. Verfahren nach Anspruch 2, **dadurch gekennzeichnet**, daß ein Polymer verwendet wird, dessen Carbonsäureanhydridgruppen Maleinsäureanhydrid zugrunde liegt.

9. Verfahren nach Anspruch 2, **dadurch gekennzeichnet**, daß ein Polymer verwendet wird, dessen tert.-Butylestergruppen Acrylsäure-, Methacrylsäure-, Vinylbenzoesäure- oder Zimtsäure-tert.-butylester zugrunde liegt.

10. Verfahren nach Anspruch 8 oder 9, **dadurch gekennzeichnet**, daß ein Copolymer aus Maleinsäureanhydrid und Methacrylsäure-tert.-butylester verwendet wird.

11. Verfahren nach Anspruch 1 oder 2, **dadurch gekennzeichnet**, daß ein Polymer verwendet wird, dessen tert.-Butoxycarbonyloxygruppen tert.-Butoxycarbonyloxystyrol oder -maleinimid zugrunde liegt.

12. Verfahren nach Anspruch 2, **dadurch gekennzeichnet**, daß die Silylierung mit einer polaren, protischen Silylierungslösung erfolgt.

13. Verfahren nach Anspruch 12, **dadurch gekennzeichnet**, daß als Silylierungslösung eine alkoholische Lösung eines Aminosiloxans verwendet wird, insbesondere eine Lösung in einem Gemisch von Ethanol und Isopropanol.

## Claims

1. Process for the production of sub-micron photolithographic patterns, characterised in
- that there is applied onto a substrate a photoresist layer consisting of
a polymer containing tert.-butyl ester or tert.-butoxycarbonyloxy groups,
a photoactive component in the form of an ester of a naphthoquinonediazide-4-sulphonic acid of the structure 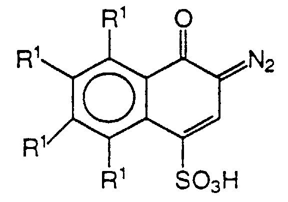 with an aromatic hydroxy compound of the structure 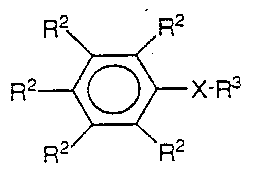 wherein the following applies:
R¹ = H, alkyl, haloalkyl, alkoxy, phenyl, halophenyl, phenoxy or halogen,
R² = H, OH, alkyl, haloalkyl, alkoxy, phenyl, halophenyl, phenoxy or halogen,
R³ = alkyl, haloalkyl, phenyl, halophenyl or mono-, di- or trihydroxyphenyl and
X = CO or SO₂,
with the proviso that the hydroxy compound has at least one OH group and that 1 to 4 naphthoquinonediazide-4-sulphonic acid residues are attached to the hydroxy compound via SO₂-O groups, and a suitable solvent,
- that the photoresist layer is dried,
- that the photoresist layer is exposed in accordance with the image,
- that the exposed photoresist layer is subjected to a heat treatment in the range between 120 and 150°C for a period of 100 to 600 s,
- and that the photoresist layer treated in this manner is wet-developed.

2. Process for the production of sub-micron photolithographic patterns, characterised in
- that a bottom resist is applied onto a substrate,
- that a layer of a photoresist consisting of a polymer containing carboxylic anhydride groups and tert.-butyl ester or tert.-butylcarbonyloxy groups,
a photoactive component in the form of an ester of a naphthoquinonediazide-4-sulphonic acid of the structure 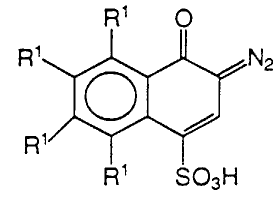 with an aromatic hydroxy compound of the structure 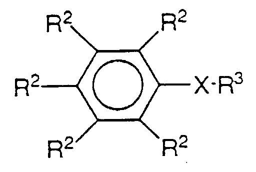 wherein the following applies:
R¹ = H, alkyl, haloalkyl, alkoxy, phenyl, halophenyl, phenoxy or halogen,
R² = H, OH, alkyl, haloalkyl, alkoxy, phenyl, halophenyl, phenoxy or halogen,
R³ = alkyl, haloalkyl, phenyl, halophenyl or mono-, di- or trihydroxyphenyl and
X = CO or SO₂,
with the proviso that the hydroxy compound has at least one OH group and that 1 to 4 naphthoquinonediazide-4-sulphonic acid residues are attached to the hydroxy compound via SO₂-O groups, and a suitable solvent,
is applied onto the bottom resist as a top resist,
- that the resist layer is dried,
- that the resist layer is exposed in accordance with the image,
- that the exposed resist layer is subjected to heat treatment in the range between 120 and 150°C for a period of 100 to 600 s,
- that the top resist treated in this manner is wet-developed,
- that the top resist is silylated,
- and that the bottom resist is dry-developed in an anisotropic oxygen plasma.

3. Process according to claim 1 or claim 2, characterised in that the hydroxy compound is 2,3,4-trihydroxybenzophenone.

4. Process according to one of claims 1 to 3, characterised in that the proportion of photoactive component in the photoresist is 20 to 40 wt.%, preferably 25 to 35 wt.%.

5. Process according to one of claims 1 to 4, characterised in that an onium compound is added to the photoactive component.

6. Process according to claim 1, characterised in that a polymer is used, the tert.-butyl ester groups of which are based on tert.-butyl esters of acrylic acid, methacrylic acid, vinylbenzoic acid or cinnamic acid.

7. Process according to claim 6, characterised in that a copolymer prepared from methacrylic acid tert.-butyl ester and methacrylic acid methyl ester is used.

8. Process according to claim 2, characterised in that a polymer is used, the carboxylic anhydride groups of which are based on maleic anhydride.

9. Process according to claim 2, characterised in that a polymer is used, the tert.-butyl ester groups of which are based on tert.-butyl esters of acrylic acid, methacrylic acid, vinylbenzoic acid or cinnamic acid.

10. Process according to claim 8 or 9, characterised in that a copolymer prepared from maleic anhydride and methacrylic acid tert.-butyl ester is used.

11. Process according to claim 1 or 2, characterised in that a polymer is used, the tert.-butoxycarbonyloxy groups of which are based on tert.-butoxycarbonyloxystyrene or -maleimide.

12. Process according to claim 2, characterised in that silylation is performed with a polar, protic silylating solution.

13. Process according to claim 12, characterised in that an alcoholic solution of an aminosiloxane, in particular a solution in a mixture of ethanol and isopropanol, is used as the silylating solution.

## Revendications

1. Procédé pour la formation d'une structure photolithographique dans le domaine du sous-micron, caractérisé
- en ce qu'on applique, sur un substrat, une couche de photoréserve constituée par
un polymère contenant des groupes d'esters tert.-butyliques ou des groupes tert.-butoxycarbonyloxy,
un composant photoactif sous forme d'un ester, d'un acide naphtoquinonediazide-4-sulfonique répondant à la structure 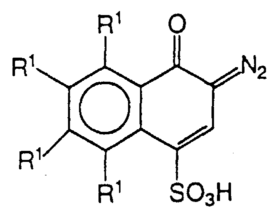 avec un composé hydroxyle aromatique répondant à la structure 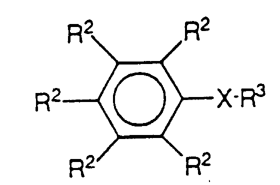 dans lesquelles
R¹ représente un atome d'hydrogène, un groupe alkyle, un groupe halogénalkyle, un groupe alcoxy, un groupe phényle, un groupe halogénophényle, un groupe phénoxy ou un atome d'halogène,
R² représente un atome d'hydrogène, un groupe OH, un groupe alkyle, un groupe halogénalkyle, un groupe alcoxy, un groupe phényle, un groupe halogénophényle, un groupe phénoxy ou un atome d'halogène,
R³ représente un groupe alkyle, un groupe halogénalkyle, un groupe phényle, un groupe halogénophényle ou un groupe mono-, di- ou trihydroxyphényle, et
X représente un groupe CO ou un groupe SO₂,
avec cette mesure que le composé hydroxyle présente au moins un groupe OH et qu'au composé hydroxyle, soient reliés - via des groupements SO₂-O - de 1 à 4 radicaux d'acide 4-naphtoquinonediazide-4-sulfonique,
et un solvant approprié,
- en ce qu'on sèche la couche de photoréserve,
- en ce qu'on expose photographiquement la couche de photoréserve,
- en ce qu'on soumet la couche de photoréserve exposée à un traitement thermique dans le domaine entre 120 et 150°C pendant un laps de temps de 100 à 600 s,
- et en ce qu'on développe à l'état humide la couche de photo réserve traitée de la sorte.

2. Procédé pour la formation d'une structure photolithographique dans le domaine du sous-micron, caractérisé
- en ce qu'on applique une réserve de base sur un substrat,
- en ce qu'on applique sur la réserve de base, à titre de réserve de sommet, une couche d'une photoréserve constituée par un polymère contenant des groupes d'anhydrides carboxyliques et des groupes d'esters tert.-butyliques ou des groupes tert.-butoxycarbonyloxy, un composant photoactif sous forme d'un ester, d'un acide naphtoquinonediazide-4-sulfonique répondant à la structure 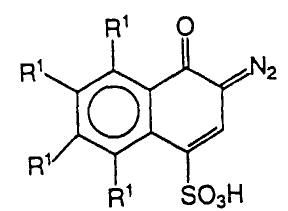 avec un composé hydroxyle aromatique répondant à la structure 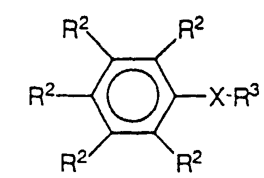 dans lesquelles
R¹ représente un atome d'hydrogène, un groupe alkyle, un groupe halogénalkyle, un groupe alcoxy, un groupe phényle, un groupe halogénophényle, un groupe phénoxy ou un atome d'halogène,
R² représente un atome d'hydrogène, un groupe OH, un groupe alkyle, un groupe halogénalkyle, un groupe alcoxy, un groupe phényle, un groupe halogénophényle, un groupe phénoxy ou un atome d'halogène,
R³ représente un groupe alkyle, un groupe halogénalkyle, un groupe phényle, un groupe halogénophényle ou un groupe mono-, di- ou trihydroxyphényle, et
X représente un groupe CO ou un groupe SO₂,
avec cette mesure que le composé hydroxyle présente au moins un groupe OH et qu'au composé hydroxyle, soient reliés - via des groupements SO₂-O - de 1 à 4 radicaux d'acide 4-naphtoquinonediazide-4-sulfonique,
et un solvant approprié,
- en ce qu'on sèche la couche de réserve,
- en ce qu'on expose photographiquement la couche de réserve,
- en ce qu'on soumet la couche de réserve exposée à un traitement thermique dans le domaine entre 120 et 150°C pendant un laps de temps de 100 à 600 s,
- en ce qu'on développe à l'état humide la réserve de sommet ainsi traitée,
- en ce qu'on soumet la réserve de sommet à une silylation,
- et en ce qu'on développe à l'état sec la réserve de base dans un plasma d'oxygène anisotrope.

3. Procédé selon la revendication 1 ou 2, caractérisé en ce que le composé hydroxyle est la 2,3,4-trihydroxybenzophénone.

4. Procédé selon les revendications 1 à 3, caractérisé en ce que la fraction de la photoréserve en composant photoactif représente de 20 à 40% en masse, de préférence de 25 à 35% en masse.

5. Procédé selon les revendications 1 à 4, caractérisé en ce qu'on ajoute au composant photoactif un composé d'onium.

6. Procédé selon la revendication 1, caractérisé en ce qu'on utilise un polymère dont les groupes d'esters tert.-butyliques sont à base d'esters tert.-butyliques de l'acide acrylique, de l'acide méthacrylique, de l'acide vinylbenzoïque ou de l'acide cinnamique.

7. Procédé selon la revendication 6, caractérisé en ce qu'on utilise un copolymère d'ester tert.-butylique de l'acide méthacrylique et d'ester méthylique de l'acide méthacrylique.

8. Procédé selon la revendication 2, caractérisé en ce qu'on utilise un polymère dont les groupes d'anhydrides carboxyliques sont à base d'anhydride maléique.

9. Procédé selon la revendication 2, caractérisé en ce qu'on utilise un polymère dont les groupes d'esters tert.-butyliques sont à base d'esters tert.-butyliques de l'acide acrylique, de l'acide méthacrylique, de l'acide vinylbenzoïque ou de l'acide cinnamique.

10. Procédé selon la revendication 8 ou 9, caractérisé en ce qu'on utilise un copolymère d'anhydride maléique et d'ester tert.-butylique de l'acide méthacrylique.

11. Procédé selon la revendication 1 ou 2, caractérisé en ce qu'on utilise un polymère dont les groupes tert.-butoxycarbonyloxy sont à base de tert.-butoxycarbonyloxystyrène ou de tert.-butoxycarbonyloxymaléimide.

12. Procédé selon la revendication 2, caractérisé en ce qu'on effectue la silylation avec une solution de silylation protique polaire.

13. Procédé selon la revendication 12, caractérisé en ce qu'on utilise, à titre de solution de silylation, une solution alcoolique d'un aminosiloxane, en particulier une solution dans un mélange d'éthanol et d'isopropanol.
